# EUROPEAN PATENT SPECIFICATION

(11) **EP 4 290 508 B1**
(45) Date of publication and mention of the grant of the patent: **10.12.2025**
(21) Application number: 23177623.8
(22) Date of filing: 06.06.2023
(51) Int. Cl.: G10H 1/02, H03F 1/32, H03F 3/217, G10H 3/18, H04R 3/00

(54) **CLIPPING CONTROL FOR MUSIC AMPLIFIER**
BEGRENZERSTEUERUNG FÜR MUSIKVERSTÄRKER
CONTRÔLEUR D'ÉCRÊTAGE POUR AMPLIFICATEUR D' INSTRUMENTS DE MUSIQUE

(30) Priority: 08.06.2022 JP 2022092931
(43) Date of publication of application: 13.12.2023
(73) Proprietor: Casio Computer Co., Ltd., Tokyo 151-8543 (JP)
(72) Inventor: YAMADA, Kenta, Tokyo, 205-8555 (JP); OKUZAKI, Kenji, Tokyo, 205-8555 (JP); ICHIKAWA, Satoshi, Tokyo, 205-8555 (JP)
(74) Representative: Plougmann Vingtoft a/s

(56) References cited:
- US-A1- 2002 172 378
- US-A1- 2013 136 278

## Description

### TECHNICAL FIELD

The disclosure of the present specification relates to an electronic device, a method, and a program.

### BACKGROUND ART

An electronic musical instrument, which is an example of an electronic device, is common (see, for example, Japanese Patent Application Laid-Open Publication No. 2004-264501). This type of electronic musical instrument protects a speaker by, for example, clipping an input voltage to a speaker using a clip function of a power amplifier.

For example, assume a case of generating an attack sound whose level is high instantaneously. In this case, peaks of the attack sound higher than a certain level may be clipped, and the attack sound may be distorted. It is preferable to protect the speaker while avoiding occurrence of such distortion of the sound. US 2002/172378 A1 discloses an audio amplifier system comprising input preprocessor, adaptive dynamic compander, output processor for e.g. speaker equalization, noise compensation, soft clipping, amplification. The input is compared to thresholds defining a clip region. If within, time derivative of the current and previous input signal are calculated to established a smooth clip signal. Variable attack and release dynamically modify the compander response time to varying input levels. Look-ahead output clip detector minimizes output clipping distortion for signals changing faster than the reaction time of the adaptive dynamic compander.

### SUMMARY OF INVENTION

The invention is as disclosed by the appended claims.

### BRIEF DESCRIPTION OF DRAWINGS

Exemplary embodiment of the present invention will be described in detail based on the following figures, wherein:
Fig. 1 is a block diagram for explaining a schematic configuration of an electronic musical instrument according to an embodiment of the present invention;
Fig. 2A is a diagram illustrating an example of a table for dynamically changing a clip value for audio signal in the embodiment of the present invention;
Fig. 2B is a diagram illustrating an example of a table for dynamically changing the clip value for audio signal in the embodiment of the present invention;
Fig. 3A is a diagram for explaining an example in which an output waveform from a speaker is shaped by a dynamic change of the clip value for audio signal in the embodiment of the present invention;
Fig. 3B is a diagram for explaining an example in which the output waveform from the speaker is shaped by a dynamic change of the clip value for audio signal in the embodiment of the present invention;
Fig. 4 is a diagram illustrating a correlation between a current value allowed in the speaker and the time according to the embodiment of the present invention;
Fig. 5 is a block diagram illustrating a specific configuration of the electronic musical instrument according to the embodiment of the present invention;
Fig. 6 is a flowchart illustrating a process of dynamically changing the clip value, which is executed by the electronic musical instrument according to the embodiment of the present invention; and
Fig. 7 is a block diagram for explaining a schematic configuration of an electronic musical instrument according to another embodiment of the present invention.

### DESCRIPTION OF EMBODIMENTS

An electronic device, and a method and a program executed by the electronic device, which is an example of a computer, according to an embodiment of the present invention will be described in detail with reference to the drawings.

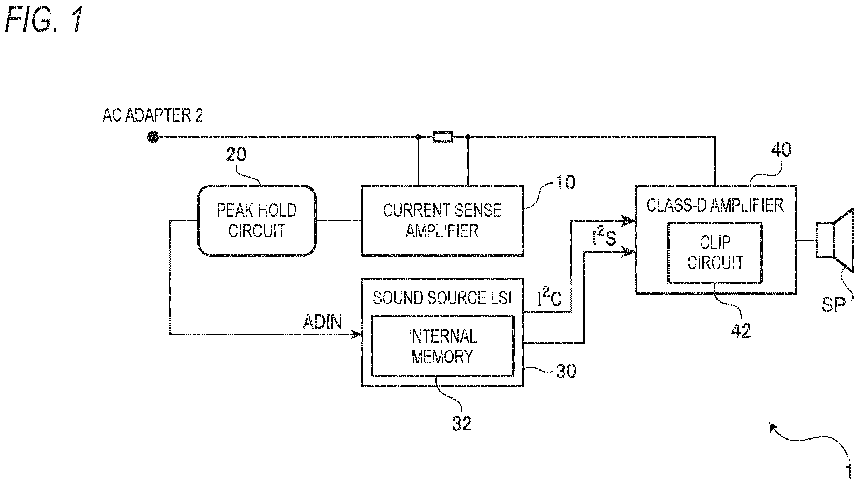

Fig. 1 is a block diagram for explaining a schematic configuration of an electronic musical instrument 1 which is an example of the electronic device according to the embodiment of the present invention. The electronic musical instrument 1 is, for example, an electronic keyboard. The electronic musical instrument 1 may be an electronic keyboard instrument other than an electronic keyboard, or may be another electronic musical instrument such as an electronic percussion instrument, an electronic wind instrument, or an electronic stringed instrument.

The electronic musical instrument 1 operates by power supplied from an AC adapter 2. As schematically illustrated in Fig. 1, the electronic musical instrument 1 includes a current sense amplifier 10, a peak hold circuit 20, a sound source LSI (Large-Scale Integration) 30, a class-D amplifier 40, and a speaker SP.

The current sense amplifier 10 is installed on a power supply path from the AC adapter 2 to the class-D amplifier 40, and measures a voltage drop at a shunt resistor as a value indicating a current consumption in the class-D amplifier 40.

The peak hold circuit 20 detects a peak value of the value measured by the current sense amplifier 10. Specifically, the peak hold circuit 20 holds the peak value of the voltage drop indicating the current consumption in the class-D amplifier 40, and outputs the peak value to an ADIN terminal of the sound source LSI 30.

The sound source LSI 30 is an example of at least one processor, and includes, for example, a single processor or multiple processors. In a case of a configuration including multiple processors, the sound source LSI 30 may be packaged as a single device, or may include a plurality of devices physically separated inside the electronic musical instrument 1.

The sound source LSI 30 obtains a value indicating the current consumption in the class-D amplifier 40 from the peak value input to the ADIN terminal. The value indicating the current consumption is an example of a value indicating the power supplied to the amplifying unit. For the sake of convenience, the value indicating the current consumption in the class-D amplifier 40 will be referred to as a "current consumption value CCV".

The class-D amplifier 40 is an example of an amplifying unit for amplifying an input signal (an audio signal in the present embodiment).

The current sense amplifier 10, the peak hold circuit 20, and the sound source LSI 30 operate as an acquisition unit for obtaining the current consumption value CCV.

The sound source LSI 30 shapes the waveform of the output signal output from the class-D amplifier 40 by controlling a waveform shaping unit depending on the current consumption value CCV. In the present embodiment, the "waveform shaping unit" shapes the waveform of the output signal output from the amplifying unit, and specifically is a clip circuit 42 included in the class-D amplifier 40. The clip circuit 42 clips an audio signal output from the class-D amplifier 40 (an example of the output signal) to protect the speaker SP.

When the sound source LSI 30 obtains a current consumption value CCV larger than a first threshold, the sound source LSI 30 changes the clip value by the clip circuit 42 in a first pattern. More specifically, the first pattern is a pattern in which a clip value for audio signal is gradually decreased with the passage of time. Here, the clip value indicates a certain potential for clipping an audio signal. That is, in the first pattern, the potential for clipping an audio signal is gradually decreased with the passage of time. That is, the clip value decreases (the potential for clipping becomes lower) with the passage of time, thereby decreasing the amplitude of the audio signal clipped by the clip circuit 42. In the first pattern, the potential for clipping becomes substantially constant since a certain time point.

When the sound source LSI 30 obtains a current consumption value CCV smaller than a second threshold that is lower than the first threshold, the sound source LSI 30 changes the clip value by the clip circuit 42 in a second pattern. More specifically, the second pattern is a pattern in which a clip value for audio signal is gradually increased with the passage of time. In the second pattern, the potential for clipping becomes substantially constant since a certain time point.

An internal memory 32 of the sound source LSI 30 stores table T1 for changing the clip value in the first pattern with the passage of time, and stores table T2 for changing the clip value in the second pattern with the passage of time.

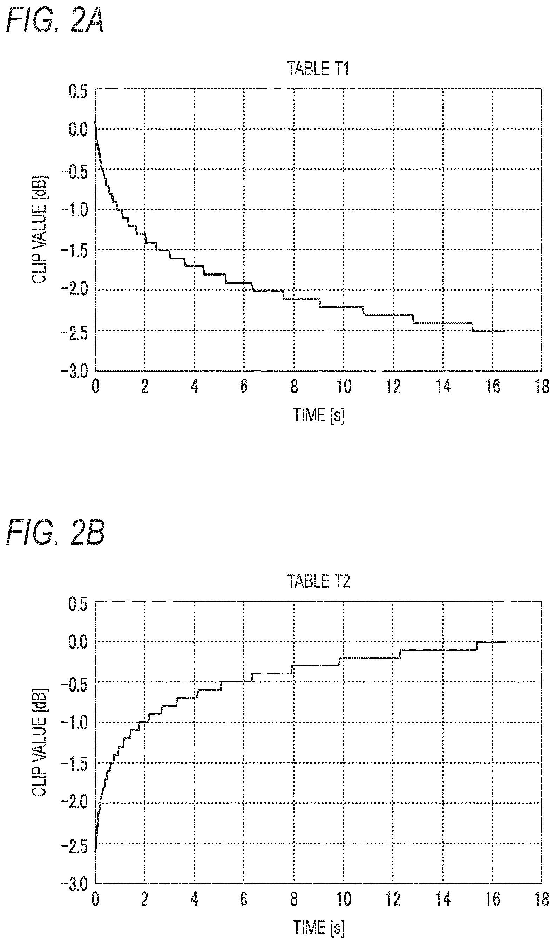

Fig. 2A illustrates an example of table T1. Fig. 2B illustrates an example of table T2. In each of Figs. 2A and 2B, the vertical axis represents the clip value for audio signal (unit: dB), and the horizontal axis represents the time (unit: second).

When the current consumption value CCV is larger than the first threshold, the sound source LSI 30 decreases the clip value for clipping the audio signal with the passage of time according to table T1. When the current consumption value CCV is smaller than the second threshold, the sound source LSI 30 increases the clip value for clipping the audio signal with the passage of time in accordance with table T2. In this manner, the sound source LSI 30 dynamically changes the clip value for the audio signal output from the class-D amplifier 40 depending on the current consumption value CCV.

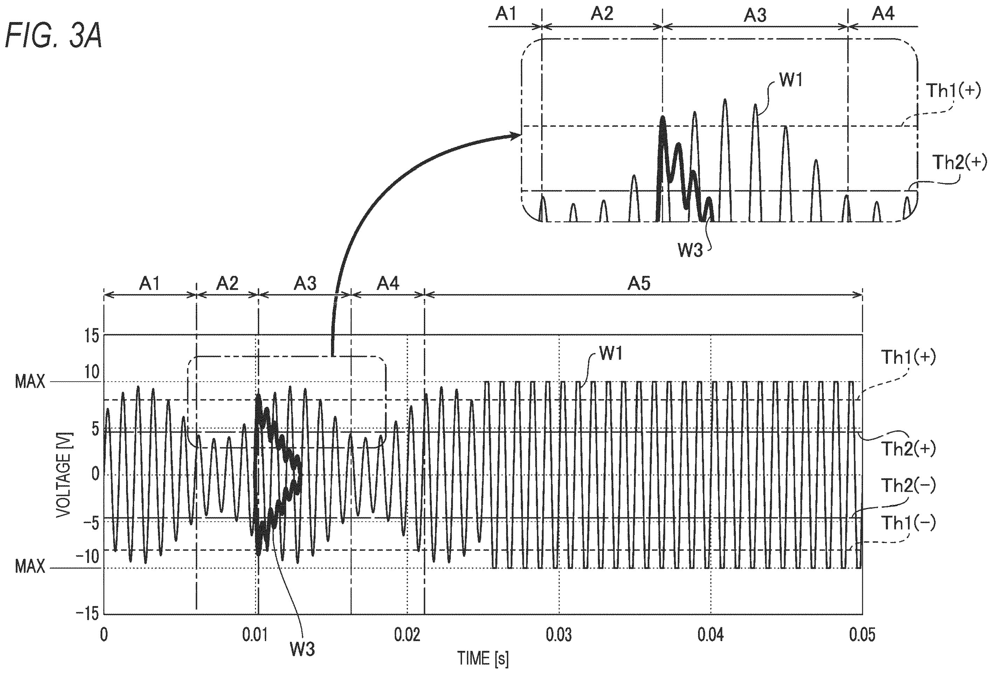

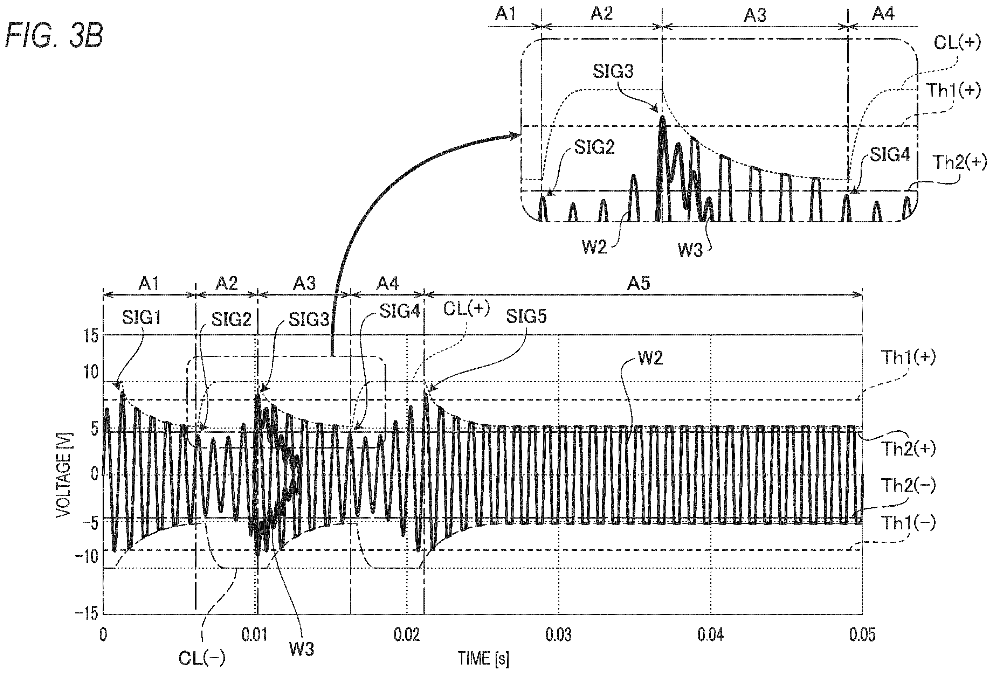

Figs. 3A and 3B are diagrams for explaining an example in which the output waveform from the speaker SP is shaped by the dynamic change in the clip value by the sound source LSI 30. Fig. 3A illustrates an example of the output waveform without applying the process of dynamically changing a clip value. Fig. 3B illustrates an example of the output waveform when the process of dynamically changing the clip value according to the present embodiment is applied to the output waveform example of Fig. 3A. In each of Figs. 3A and 3B, the vertical axis represents the voltage (unit: V), and the horizontal axis represents the time (unit: second). In Figs. 3A and 3B, the time axis is divided into periods A1 to A5 for the sake of convenience.

In Fig. 3A, a speaker output waveform W1 indicates a waveform output from the speaker SP when the audio signal is not clipped. The speaker output waveform W1 has a correlation with the current consumption value CCV. That is, the amplitude of the speaker output waveform W1 increases as the current consumption value CCV becomes larger, and the amplitude of the speaker output waveform W1 decreases as the current consumption value CCV becomes smaller.

In Fig. 3A, an attack waveform W3 indicates a waveform of an attack sound included in the speaker output waveform W1. Here, the attack sound refers to a sound whose output signal instantaneously reaches a high level when a certain key of the keyboard 60 of the electronic musical instrument 1 is pressed instantaneously, which will be described later. For example, the attack waveform W3 in Fig. 3A (and Fig. 3B) is an exemplary waveform for indicating an attack sound, and is not limited thereto.

For example, a high-level speaker output waveform W1 being continuously output from the speaker SP may result in permanent destruction of the speaker SP. The high-level speaker output waveform W1 is a waveform having a large absolute value when taking a reference value 0 V (reference potential) as 0, and is, for example, a waveform larger than a clip-on threshold Th1 to be described later.

In Fig. 3A, the attack waveform W3 exceeds the clip-on threshold Th1. In order to prevent the speaker SP from permanent destruction, it is conceivable to clip the speaker output waveform W1. However, if the speaker output waveform W1 is simply clipped, the peak of the attack waveform W3 is clipped, and the attack sound is distorted.

Therefore, in the present embodiment, the clip value is dynamically changed to protect the speaker SP while preventing the sound from being distorted due to an output signal of a high level being clipped. The dynamic change of the clip value will be specifically described with reference to Fig. 3B.

Fig. 3B illustrates a clip waveform W2 as a waveform output from the speaker SP when the clip value for audio signal is dynamically changed.

The clip-on thresholds Th1 (+) and Th1 (-) are examples of the first threshold. The clip-on threshold Th1 (+) and the clip-on threshold Th1 (-) have the same absolute value and different signs. Hereinafter, the clip-on threshold Th1 (+) and the clip-on threshold Th1 (-) are collectively referred to as the "clip-on threshold Th1". For example, the "waveform larger the clip-on threshold Th1" means a waveform larger than the absolute value of the clip-on threshold Th1 (+) and the clip-on threshold Th1 (-). For example, a "waveform smaller than the clip-on threshold Th1" means a waveform smaller than the absolute value of the clip-on threshold Th1 (+) and the clip-on threshold Th1 (-).

Clip-off thresholds Th2 (+) and Th2 (-) are examples of the second threshold. The clip-off threshold Th2 (+) and the clip-off threshold Th2 (-) have the same absolute value and different signs. Hereinafter, the clip-off threshold Th2 (+) and the clip-off threshold Th2 (-) are collectively referred to as a "clip-off threshold Th2". For example, a "waveform larger the clip-off threshold Th2" means a waveform larger than the absolute value of the clip-off threshold Th2 (+) and Th2 (-). For example, a "waveform smaller the clip-off threshold Th2" means a waveform smaller than the absolute value of the clip-off threshold Th2 (+) and Th2 (-).

The clip-on threshold Th1 and the clip-off threshold Th2 are stored in, for example, the internal memory 32. The current consumption value CCV is a value converted into voltage for the convenience of measuring a voltage value as a current value by the current sense amplifier 10. Correspondingly, the clip-on threshold Th1 and the clip-off threshold Th2 are also values converted into voltage.

The clip-on threshold Th1 and the clip-off threshold Th2 are set based on, for example, at least one of the rated noise voltage, the maximum input voltage, and the instantaneous maximum input voltage of the speaker SP which is an example of a predetermined circuit unit. As an example, the clip-on threshold Th1 is set to a value larger than the rated noise voltage and smaller than the maximum input voltage, and the clip-off threshold Th2 is set to a value smaller than the rated noise voltage. The rated noise voltage, the maximum input voltage, and the instantaneous maximum input voltage are defined by JIS C 5532:2014.

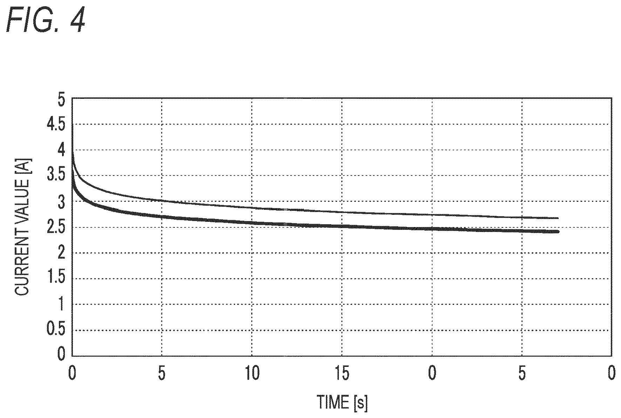

Fig. 4 is a diagram illustrating a correlation between a current value allowed in the speaker SP and the time. In Fig. 4, the vertical axis represents the current value (unit: A), and the horizontal axis represents the time (unit: second). The curve representing the correlation between the current value allowed in the speaker SP and the time is referred to as a "protective curve".

The protective curve (thin line) is a curve indicating the correlation between the current value allowed according to the specification of the speaker SP and the time, and is estimated based on the rated noise voltage, the maximum input voltage, and the instantaneous maximum input voltage of the speaker SP by the inventors. The protective curve (thick line) is a curve set by the inventors in consideration of the safety factor for the protective curve (thin line).

In the present embodiment, the clip-on threshold Th1 and the clip-off threshold Th2 are set based on the protective curve (thick line) set in consideration of the safety factor for the protective curve (thin line) indicating the limit value according to the specification of the speaker SP.

That is, in the present embodiment, the clip-on threshold Th1 and the clip-off threshold Th2 are set based on the rated noise voltage, the maximum input voltage, and the instantaneous maximum input voltage of the speaker SP.

In Fig. 3B, values CL (+) and CL (-) indicate clip values that change according to tables T1 and T2. The values CL (+) and CL (-) have different positive and negative signs, but have the same absolute value. The maximum value MAX of the values CL (+) and CL (-) is +10 V and -10 V, respectively. The maximum value is set to, for example, a value larger than the rated noise voltage and the clip-on threshold Th1 and smaller than the instantaneous maximum input voltage.

In Fig. 3B, a current consumption value CCV larger than the clip-on threshold Th1 is detected at a time point SIG1 that slightly passes 0 seconds on the time axis. Therefore, the sound source LSI 30 decreases the clip value for audio signal with the passage of time in accordance with table T1. As a result, the speaker output waveform W1 is clipped afterward in period A1, and thus the clip waveform W2 having a decreased amplitude is output from the speaker SP.

The sound source LSI 30 calculates the envelope of the speaker output waveform W1, and performs threshold determination for the calculated envelope by using the clip-on threshold Th1 and the clip-off threshold Th2.

In period A1, the input voltage to the speaker SP gradually decreases since the time point SIG1. Therefore, for example, when a large continuous sound is input, the speaker SP can be prevented from permanent destruction. In addition, since the input voltage to the speaker SP gradually decreases on the time axis, the occurrence of unnatural sound due to a rapid decrease in the input voltage is prevented.

In Fig. 3B, a current consumption value CCV smaller the clip-off threshold Th2 is detected at a time point SIG2 (around beginning of period A2). Therefore, the sound source LSI 30 increases the clip value for audio signal with the passage of time in accordance with table T2. By rapidly increasing the clip value, the electronic musical instrument 1 quickly returns to a state of being capable of outputting the original sound without a clip.

As described above, the sound source LSI 30 controls the clip circuit 42 in a second pattern such that the clip value for audio signal increases when detecting that the current consumption value CCV is larger than the reference potential (0 V) and that the current consumption value CCV becomes smaller than the clip-off threshold Th2 from a state of being larger than the clip-on threshold Th1.

In Fig. 3B, a current consumption value CCV larger than the clip-on threshold Th1 is detected at a time point SIG3 (around 0.01 second on the time axis). Specifically, an attack sound larger than the clip-on threshold Th1 (for example, the attack waveform W3 in which the input voltage to the speaker SP is instantaneously larger than the rated noise voltage) is generated.

The speaker SP can instantaneously output a large sound such as an attack sound, as defined by the maximum input voltage and the instantaneous maximum input voltage. On the other hand, the speaker SP cannot continuously output a sound higher than the rated noise voltage. Therefore, in Fig. 3B, after the time point SIG3 (immediately after the occurrence of the attack sound), the sound source LSI 30 decreases the clip value for audio signal with the passage of time in accordance with table T1.

As illustrated in table T1, the clip value for audio signal gradually decreases instead of decreasing immediately after the attack sound is generated (immediately after the detection). Therefore, the attack sound is output without the peak of the instantaneous attack waveform W3 being clipped. Therefore, it is possible to avoid the occurrence of the distortion of the attack sound due to the clipping of the peak, which improves the sound quality of the attack sound.

As described above, the sound source LSI 30 sets table T1 (in other words, the first pattern and the decrease rate of the clip value) such that at least one of feature signals included in the output signal (for example, the attack waveform W3) is not shaped by the clip circuit 42.

In addition, the sound source LSI 30 controls the clip circuit 42 in a first pattern such that the clip value for audio signal decreases when detecting that the current consumption value CCV is larger than the reference potential (0 V) and that the current consumption value CCV becomes larger than the clip-on threshold Th1 from a state of being smaller than the clip-off threshold Th2.

In Fig. 3B, in period A3 after the attack sound is generated (since the time point SIG3), the input voltage to the speaker SP is lowered in the same manner as in period A1, so that the speaker SP can be prevented from permanent destruction due to, for example, a large continuous sound being input.

In Fig. 3B, a current consumption value CCV smaller than the clip-off threshold Th2 is detected at a time point SIG4 (around beginning of period A4). In order to quickly return to a state of being capable of outputting the original sound without a clip, the sound source LSI 30 increases the clip value for audio signal with the passage of time in accordance with table T2. In addition, by rapidly increasing the clip value, even when, for example, an attack sound occurs, the peak thereof is output without being clipped. The dynamic change of the clip value can avoid the occurrence of the distortion of the attack sound due to the peak being clipped, thereby improving the sound quality of the attack sound while protecting the speaker SP.

In Fig. 3B, a current consumption value CCV larger than the clip-on threshold Th1 is detected at a time point SIG5 (around beginning of period A5). Therefore, the sound source LSI 30 decreases the clip value for audio signal with the passage of time in accordance with table T1 again. In period A5, since the speaker output waveform W1 of the large continuous sound is clipped, the speaker SP is prevented from permanent destruction.

As described above, according to the present embodiment, for example, an instantaneously high-level audio signal (a signal including an attack sound) is clipped, thereby protecting the speaker SP while avoiding the attack sound from being distorted.

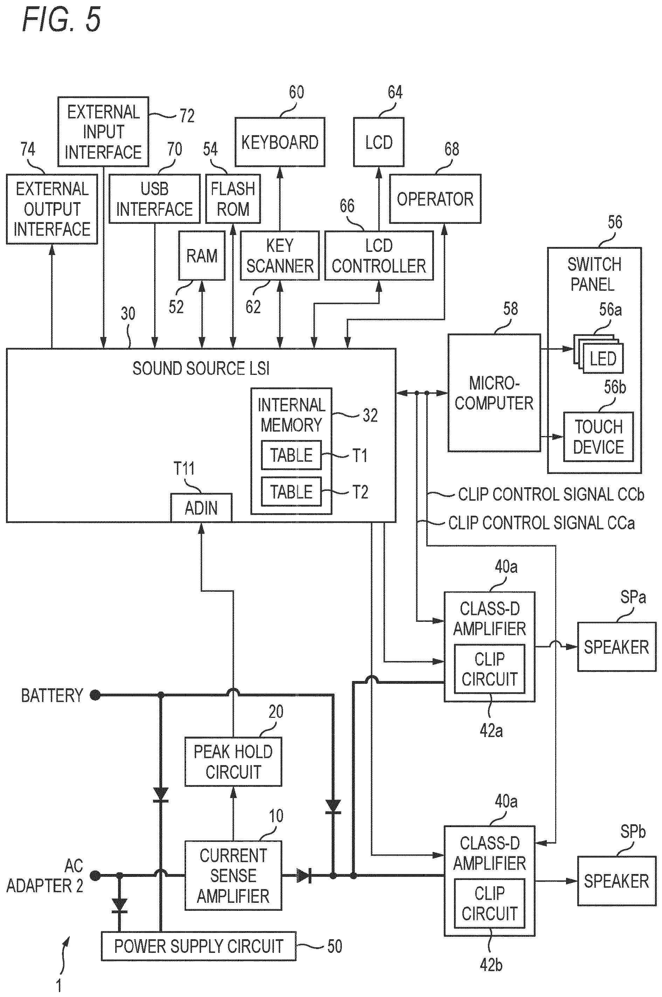

A specific configuration of the electronic musical instrument 1 will be described. Fig. 5 is a block diagram illustrating the configuration of the electronic musical instrument 1. As illustrated in Fig. 5, the electronic musical instrument 1 may include a current sense amplifier 10, a peak hold circuit 20, a sound source LSI 30, class-D amplifiers 40a and 40b, a power supply circuit 50, a RAM (Random Access Memory) 52, a flash ROM (Read Only Memory) 54, a switch panel 56, a microcomputer 58, a keyboard 60, a key scanner 62, an LCD (Liquid Crystal Display) 64, an LCD controller 66, operators 68, a USB (Universal Serial Bus) interface 70, an external input interface 72, an external output interface 74, and speakers SPa and SPb.

The power supply circuit 50 generates electric power to be supplied to each unit of the electronic musical instrument 1 from electric power supplied from the AC adapter 2 or a battery attached to the electronic musical instrument 1, and supplies the generated electric power to each unit.

The sound source LSI 30, which is an example of at least one processor, reads programs and data stored in the flash ROM 54, and comprehensively controls the electronic musical instrument 1 by using the RAM 52 as a work area.

The RAM 52 temporarily stores data and programs. The RAM 52 stores the programs, data (waveform data and the like) read from the flash ROM 54, and also data necessary for communication.

The flash ROM 54 is a nonvolatile semiconductor memory such as a flash memory, an EPROM (Erasable Programmable ROM), or an EEPROM (Electrically Erasable Programmable ROM).

The switch panel 56 is, for example, an operation panel provided on the housing of the electronic musical instrument 1, and may include a LED (Light Emitting Diode) 56a and a touch device 56b. When each of the plurality of LEDs 56a emits light, various icons for accepting various operations are displayed on the top plate of the electronic musical instrument 1.

The touch device 56b incorporates, for example, a capacitive or optical touch panel. When the user touches an icon displayed on the top board, an operation signal indicating operation details is output to the sound source LSI 30 via the microcomputer 58. By the sound source LSI 30 controlling each unit based on the operation signal, the electronic musical instrument 1 performs an operation in response to the user's operation. As an example, the user can designate a tone (guitar, bass, piano, or the like) by a touch operation on the touch device 56b.

The switch panel 56 is not limited to such a touch panel. The switch panel 56 may include mechanical, capacitive non-contact, or membrane operators, such as switches or buttons.

The keyboard 60 is a keyboard having a plurality of white keys and a plurality of black keys as a plurality of performance operators. The respective keys are associated with different pitches.

The key scanner 62 monitors key pressing and key releasing on the keyboard 60. When detecting, for example, a key-pressing operation by the user, the key scanner 62 outputs key-pressing event information to the sound source LSI 30. The key-pressing event information includes information on the pitch of the key (key number) related to the key-pressing operation. The key number may be referred to as a MIDI key or a note number.

In the present embodiment, a unit for measuring the key-pressing speed of the key (velocity value) is provided separately. The velocity value measured by this unit is also included in the key-pressing event information. For example, the respective keys are provided with a plurality of contact switches. The velocity value is measured by the difference in time during which each contact switch is conducted in response to the keys being pressed. The velocity value may be a value indicating the strength of the key-pressing operation or a value indicating the magnitude (volume) of the musical sound.

The LCD 64 is driven by the LCD controller 66. When the LCD controller 66 drives the LCD 64 in accordance with a control signal from the sound source LSI 30, a screen corresponding to the control signal is displayed on the LCD 64. The LCD 64 may be replaced with a display device such as an organic EL (Electro Luminescence). The LCD 64 may be one of operators incorporating a touch panel.

The operators 68 may include various operators for operating the electronic musical instrument 1, such as knobs (main volume knob, etc.), buttons, and pedals.

The USB interface 70 is, for example, an interface for transmitting and receiving MIDI data (MIDI message) to and from an external MIDI (Musical Instrument Digital Interface) device.

The external input interface 72 is, for example, an audio interface to which an external device such as a microphone is connected. The external output interface 74 is, for example, an audio interface to which an external device, such as an amplifier-embedded speaker or headphones, is connected.

The sound source LSI 30 reads waveform data corresponding to, for example, the tone selected by the user's operation and the key-pressing event information, and generates a musical sound based on the read waveform data. The sound source LSI 30 includes, for example, 128 generator sections, and can simultaneously generate 128 musical sounds at the maximum.

Digital musical sound data (for example, I2S format) generated by the sound source LSI 30 is input to the class-D amplifiers 40a and 40b, converted into an analog signal, amplified, and output to the speakers SPa and SPb, respectively. As a result, a musical sound corresponding to the key-pressing operation is played.

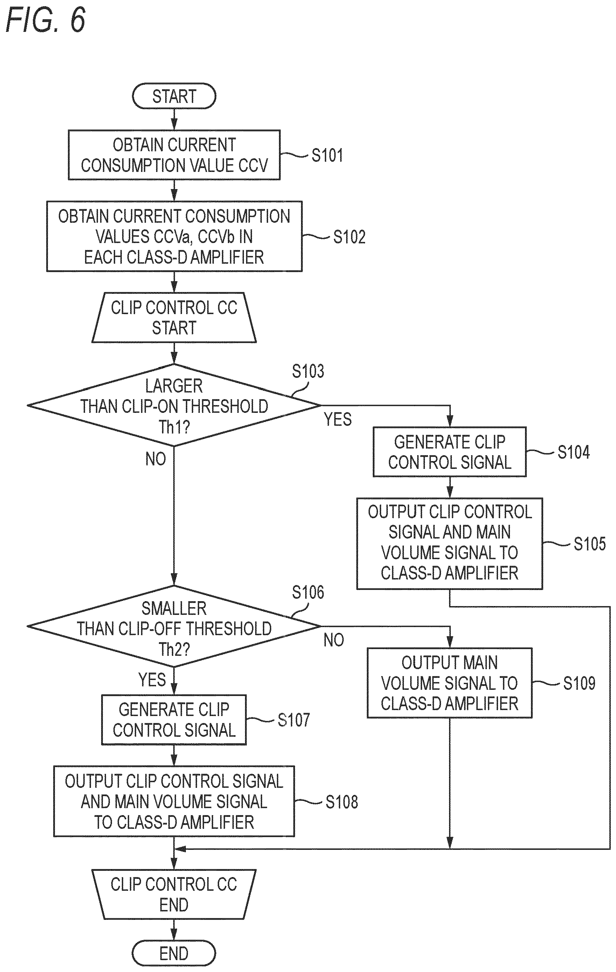

Fig. 6 is a flowchart illustrating a process of dynamically changing the clip value executed by the sound source LSI 30. The flowchart illustrated in Fig. 6 is started, for example, when the system of the electronic musical instrument 1 is started, and is repeatedly executed until the system of the electronic musical instrument 1 is stopped.

The sound source LSI 30 converts the peak value input from the peak hold circuit 20 to the ADIN terminal T11 from an analog signal to a digital signal at a predetermined sampling rate, and obtains an average value of every n periods (for example, every four times of sampling) as the current consumption value CCV (step S101). The number of samples used for calculating the average value is set in consideration of, for example, prevention of variation in peak value and delay associated with calculation of the average value.

The current consumption value CCV indicates the total current consumption value of the class-D amplifiers 40a and 40b. Therefore, the sound source LSI 30 calculates a current consumption value CCVa in the class-D amplifier 40a and a current consumption value CCVb in the class-D amplifier 40b from the current consumption value CCV (step S102). For example, the sound source LSI 30 calculates the current consumption value CCVa and the current consumption value CCVb from the current consumption value CCV on the basis of the main volume value, the boost, the cut, and the like of the equalizer set for each of the speakers SPa and SPb.

The sound source LSI 30 executes clip control CC (steps S103 to S109) for each of the class-D amplifiers 40a and 40b.

For example, the sound source LSI 30 first executes the clip control CC (steps S103 to S109) for the class-D amplifier 40a.

Specifically, the sound source LSI 30 determines whether the current consumption value CCVa is larger than the clip-on threshold Th1 (step S103). When the current consumption value CCVa is larger than the clip-on threshold Th1 (step S103: YES), the sound source LSI 30 generates the clip control signal CCa in accordance with table T1 (step S104). The clip control signal CCa is a control signal for controlling the clip circuit 42a of the class-D amplifier 40a.

The sound source LSI 30 outputs the clip control signal CCa generated in step S104 and a main volume signal Va to the class-D amplifier 40a in, for example, I2C (Inter-Integrated Circuit) format (step S105). The main volume signal Va is a signal indicating a main volume value set for the speaker SPa.

The class-D amplifier 40a amplifies the audio signal input from the sound source LSI 30 in response to the main volume signal Va, and operates the clip circuit 42a based on the clip control signal CCa to clip the audio signal that is the output signal to the speaker SPa. As a result, the clip value for audio signal decreases with the passage of time (see, for example, period A3 in Fig. 3B). Therefore, it is possible to avoid the occurrence of the distortion of the attack sound due to the peak being clipped while protecting the speaker SPa.

When the current consumption value CCVa is equal to or smaller than the clip-on threshold Th1 (step S103: NO), the sound source LSI 30 determines whether the current consumption value CCVa is smaller than the clip-off threshold Th2 (step S106). When the current consumption value CCVa is smaller than the clip-off threshold Th2 (step S106: YES), the sound source LSI 30 generates the clip control signal CCa in accordance with table T2 (step S107).

The sound source LSI 30 outputs the clip control signal CCa generated in step S107 and a main volume signal Va to the class-D amplifier 40a in, for example, I2C format (step S108).

The class-D amplifier 40a amplifies the audio signal input from the sound source LSI 30 in response to the main volume signal Va, and operates the clip circuit 42a based on the clip control signal CCa to clip the audio signal that is the output signal to the speaker SPa. As a result, the clip value for audio signal increases with the passage of time (see, for example, period A4 in Fig. 3B). Therefore, it is possible to quickly return to a state of being capable of outputting the original sound without being clipped, and to avoid the occurrence of the distortion of the attack sound due to the peak being clipped, while protecting the speaker SPa.

When the current consumption value CCVa is equal to or smaller than the clip-on threshold Th1 and equal to or larger than the clip-off threshold Th2 (step S106: NO), the sound source LSI 30 outputs the main volume signal Va to the class-D amplifier 40a in, for example, I2C format (step S109). The class-D amplifier 40a amplifies the audio signal input from the sound source LSI 30 in response to the main volume signal Va, and outputs the amplified audio signal to the speaker SPa. Even if the audio signal is not clipped, no excessive current flows through the speaker SPa, and thus the speaker SPa is free from the risk of destruction.

The sound source LSI 30 also executes the same clip control CC (steps S103 to S109) for the class-D amplifier 40b.

In brief, when the current consumption value CCVb is larger than the clip-on threshold Th1 (step S103: YES), the sound source LSI 30 generates the clip control signal CCb in accordance with table T1 (step S104). The clip control signal CCb is a control signal for controlling the clip circuit 42b of the class-D amplifier 40b. The sound source LSI 30 outputs the clip control signal CCb generated in step S104 and a main volume signal Vb to the class-D amplifier 40b (step S105). The main volume signal Vb is a signal indicating a main volume value set for the speaker SPb.

When the current consumption value CCVb is smaller than the clip-off threshold Th2 (step S106: YES), the sound source LSI 30 generates the clip control signal CCb in accordance with table T2 (step S107). The sound source LSI 30 outputs the clip control signal CCb generated in step S107 and a main volume signal Vb to the class-D amplifier 40b (step S108).

When the current consumption value CCVb is equal to or smaller than the clip-on threshold Th1 and equal to or larger than the clip-off threshold Th2 (step S106: NO), the sound source LSI 30 outputs the main volume signal Va to the class-D amplifier 40a (step S109).

When the speaker SPa and the speaker SPb (in other words, the rated noise voltage, the maximum input voltage, and the instantaneous maximum input voltage) have the same specification, the clip-on threshold Th1 and the clip-off threshold Th2 for each of the speakers SPa and SPb are set to the same value. On the other hand, when the speaker SPa and the speaker SPb have different specifications, the clip-on threshold Th1 and the clip-off threshold Th2 for each of the speakers SPa and SPb are set to different values.

That is, the internal memory 32 of the sound source LSI 30 stores a plurality of types of clip-on threshold Th1 and clip-off threshold Th2 corresponding to each of a plurality of types of speakers SP. The clip-on threshold Th1 and the clip-off threshold Th2 for each of the plurality of types of speakers SP are set in advance in, for example, the manufacturing stage.

The clip-on threshold Th1 and the clip-off threshold Th2 for each of the plurality of types of speakers SP may be automatically set by the sound source LSI 30 recognizing the model number of the speaker SP. For example, the sound source LSI 30 recognizes the type of the speaker SP as the output destination of the class-D amplifier 40, and sets the clip-on threshold Th1 and the clip-off threshold Th2 according to the type of the recognized speaker SP from among the clip-on thresholds Th1 and the clip-off thresholds Th2 stored in the internal memory 32.

As described above, according to the present embodiment, it is possible to protect the speaker SP while preventing the distortion of the sound due to a high-level output signal such as an attack sound being clipped.

In the above embodiment, the speaker SP is given as an example of the circuit unit to be protected, but the e present invention also includes a case where a circuit unit other than the speaker SP (for example, the AC adapter 2) is to be protected. That is, the clip value for the output current of the AC adapter 2 may be decreased with the passage of time when the output current value of the AC adapter 2 is larger than the clip-on threshold Th1, and the clip value for the output current of the AC adapter 2 may be increased with the passage of time when the output current value of the AC adapter 2 is smaller than the clip-off threshold Th2.

The internal memory 32 of the sound source LSI 30 may store a plurality of types of tables T1 and T2 corresponding to the plurality of types of speakers SP. That is, the internal memory 32 may operate as a storage unit for storing a plurality of types of first patterns and second patterns corresponding to the plurality of types of speakers SP, respectively.

In this case, the sound source LSI 30 may obtain tables T1 and T2 according to the type of the speaker SP as the output destination of the class-D amplifier 40 from among the plurality of types of tables T1 and T2 stored in the internal memory 32, and control the clip circuit 42 with the obtained tables T1 and T2. Further, tables T1 and T2 may be set based on the protective curve set in consideration of the safety factor (the thick line in Fig. 4) with respect to the protective curve indicating the limit value in the specification according to the type of the speaker SP (the thin line in Fig. 4).

The internal memory 32 of the sound source LSI 30 may store two functions approximating the respective curves of tables T1 and T2 (see Fig. 2A and Fig. 2B) instead of tables T1 and T2. That is, the sound source LSI 30 may control the clip circuit 42 in a pattern defined by a function.

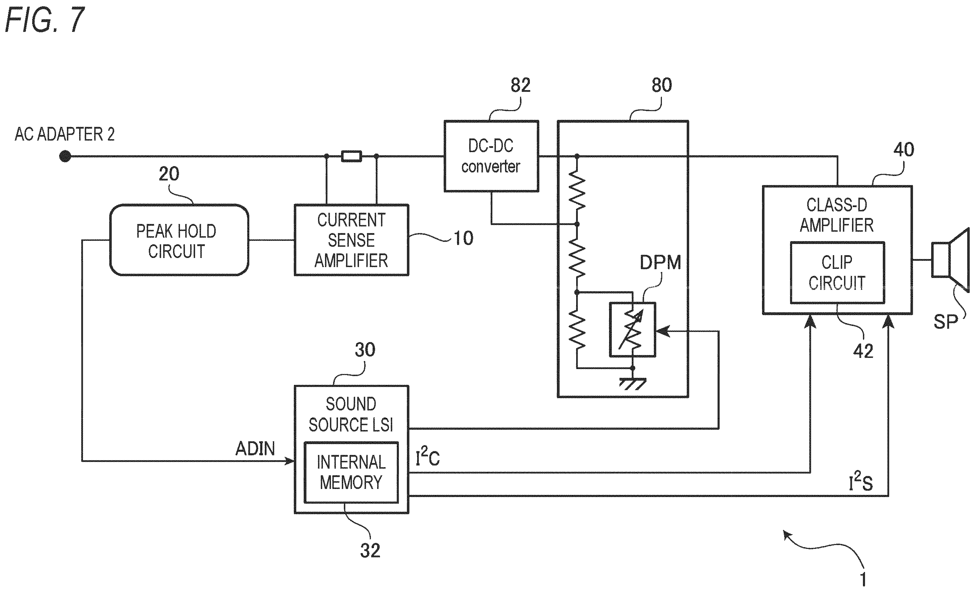

Fig. 7 is a block diagram for explaining a schematic configuration of an electronic musical instrument 1 according to another embodiment of the present invention. The electronic musical instrument 1 according to the other embodiment may include a voltage dividing circuit 80 and a DC-DC converter 82. The voltage dividing circuit 80 may include a digital potentiometer DPM.

In another embodiment, the sound source LSI 30 controls the resistance value of the digital potentiometer DPM in accordance with table T1 or T2 when the current consumption value CCV is larger than the clip-on threshold Th1 or smaller than the clip-off threshold Th2. When the voltage division ratio changes as the resistance value of the digital potentiometer DPM changes under the control of the sound source LSI 30, the output voltage of the DC-DC converter 82 installed on the power supply path from the AC adapter 2 to the class-D amplifier 40 changes, and the supply power to the speaker SP changes dynamically.

In another embodiment, similarly to the embodiment described above, the clip value for audio signal, which is the output signal to the speaker SP, decreases with the passage of time or increases with the passage of time. As a result, it is possible to protect the speaker SP while preventing the distortion of the sound due to a high-level output signal such as an attack sound being clipped.

## Claims

1. An electronic device (1) comprising:
an amplifier (40) configured to amplify an input signal and output an output signal obtained by shaping the amplified input signal; and
at least one processor (30), wherein
the at least one processor (30) is configured to:
obtain a value (CCV) indicating a current consumption in the amplifier (40);
control the amplifier (40) in a first pattern such that a clip value for the output signal decreases, when detecting that the value is larger than a reference potential and that the value becomes larger than a first threshold larger than a second threshold from a state of being smaller than the second threshold; and
control the amplifier (40) in a second pattern such that the clip value for the output signal increases, when detecting that the value is larger than the reference potential and that the value becomes smaller than the second threshold from a state of being larger than the first threshold.

2. The electronic device (1) according to claim 1, wherein the at least one processor (30) is configured to
set the first pattern such that at least one of feature signals included in the output signal is not shaped by the amplifier (40).

3. The electronic device (1) according to claim 1, wherein
the first pattern is a pattern in which the clip value for the output signal decreases with passage of time, and
the second pattern is a pattern in which the clip value for the output signal increases with passage of time.

4. The electronic device (1) according to claim 1, wherein
the amplifier (40) includes a clip circuit (42) configured to clip the output signal, and the at least one processor (30) is configured to:
change a clip value of the clip circuit (42) in the first pattern such that the clip value for the output signal decreases with passage of time, when the value is larger than the first threshold; and
change the clip value in the second pattern such that the clip value for the output signal increases with passage of time, when the value is smaller than the second threshold.

5. The electronic device (1) according to claim 1, wherein
the at least one processor (30) is configured to:
obtain, with a peak hold circuit (20) configured to detect a peak value of a value measured by a current sense amplifier (10) installed on a power supply path to the amplifier (40), the value indicating the power from the detected peak value.

6. The electronic device (1) according to claim 1, wherein
the first threshold and the second threshold are values set based on at least one of a rated noise voltage, a maximum input voltage, and an instantaneous maximum input voltage of a predetermined circuit unit (SP).

7. The electronic device (1) according to claim 6, wherein
the input signal and the output signal are audio signals, and
the predetermined circuit unit (SP) is a speaker (SP) to which the audio signal output from the amplifier (40) is input.

8. The electronic device (1) according to claim 7, further comprising:
a memory (32) storing a plurality of types of the first pattern and the second pattern corresponding to the plurality of types of the speaker (SP), wherein
the at least one processor (30) is configured to:
obtain the first pattern and the second pattern corresponding to a type of the speaker (SP) that is an output destination of the amplifier (40) from among the plurality of types of the first pattern and the second pattern; and
control the amplifier (40) in the obtained first pattern and second pattern.

9. The electronic device (1) according to any one of claims 1 to 8, wherein
the electronic device (1) is an electronic musical instrument having a plurality of keys (60).

10. A method performed by at least one processor (30), comprising:
obtaining a value (CCV) indicating a current consumption in power supplied to an amplifier (40) configured to amplify an input signal and output an output signal obtained by shaping the amplified input signal;
controlling the amplifier (40) in a first pattern such that a clip value for the output signal decreases, when detecting that the value is larger than a reference potential and that the value becomes larger than a first threshold larger than a second threshold from a state of being smaller than the second threshold; and
controlling the amplifier (40) in a second pattern such that the clip value for the output signal increases, when detecting that the value is larger than the reference potential and that the value becomes smaller than the second threshold from a state of being larger than the first threshold.

11. A program for causing at least one processor (30) to execute a process, the process comprising:
obtaining a value (CCV) indicating a current consumption in an amplifier (40) configured to amplify an input signal and output an output signal obtained by shaping the amplified input signal;
controlling the amplifier (40) in a first pattern such that a clip value for the output signal decreases, when detecting that the value is larger than a reference potential and that the value becomes larger than a first threshold larger than a second threshold from a state of being smaller than the second threshold; and
controlling the amplifier (40) in a second pattern such that the clip value for the output signal increases, when detecting that the value is larger than the reference potential and that the value becomes smaller than the second threshold from a state of being larger than the first threshold.

## Patentansprüche

1. Elektronische Vorrichtung (1), umfassend:
einen Verstärker (40), der so konfiguriert ist, dass er ein Eingangssignal verstärkt und ein Ausgangssignal ausgibt, das durch Formen des verstärkten Eingangssignals erhalten wird; und
mindestens einen Prozessor (30), wobei
der mindestens eine Prozessor (30) konfiguriert ist zum:
Erhalten eines Wertes (CCV), der einen Stromverbrauch in dem Verstärker (40) angibt;
Steuern des Verstärkers (40) in einem ersten Muster, so dass ein Begrenzungswert für das Ausgangssignal abnimmt, wenn detektiert wird, dass der Wert größer als ein Referenzpotential ist und dass der Wert größer als ein erster Schwellenwert wird, der größer als ein zweiter Schwellenwert ist, ausgehend von einem Zustand, in dem er kleiner als der zweite Schwellenwert ist; und
Steuern des Verstärkers (40) in einem zweiten Muster, so dass der Begrenzungswert für das Ausgangssignal zunimmt, wenn detektiert wird, dass der Wert größer als das Referenzpotential ist und dass der Wert kleiner als der zweite Schwellenwert wird, ausgehend von einem Zustand, in dem er größer als der erste Schwellenwert ist.

2. Elektronische Vorrichtung (1) nach Anspruch 1, wobei der mindestens eine Prozessor (30) konfiguriert ist zum
Einstellen des ersten Musters, so dass mindestens eines der in dem Ausgangssignal enthaltenen Merkmalsignale nicht durch den Verstärker (40) geformt wird.

3. Elektronische Vorrichtung (1) nach Anspruch 1, wobei
das erste Muster ein Muster ist, bei dem der Begrenzungswert für das Ausgangssignal mit der Zeit abnimmt, und
das zweite Muster ein Muster ist, bei dem der Begrenzungswert für das Ausgangssignal mit der Zeit zunimmt.

4. Elektronische Vorrichtung (1) nach Anspruch 1, wobei
der Verstärker (40) eine Begrenzungsschaltung (42) enthält, die so konfiguriert ist, dass sie das Ausgangssignal begrenzt, und
der mindestens eine Prozessor (30) konfiguriert ist zum:
Ändern eines Begrenzungswerts der Begrenzungsschaltung (42) in dem ersten Muster, so dass der Begrenzungswert für das Ausgangssignal mit der Zeit abnimmt, wenn der Wert größer als der erste Schwellenwert ist; und
Ändern des Begrenzungswerts in dem zweiten Muster, so dass der Begrenzungswert für das Ausgangssignal mit der Zeit zunimmt, wenn der Wert kleiner als der zweite Schwellenwert ist.

5. Elektronische Vorrichtung (1) nach Anspruch 1, wobei
der mindestens eine Prozessor (30) konfiguriert ist zum:
Erhalten, mit einer Spitzen-Halte-Schaltung (20), die so konfiguriert ist, dass sie einen Spitzenwert eines von einem Strommessverstärker (10) gemessenen Wertes detektiert, der in einem Stromversorgungspfad zu dem Verstärker (40) installiert ist, des Wertes, der die Leistung aus dem detektierten Spitzenwert angibt.

6. Elektronische Vorrichtung (1) nach Anspruch 1, wobei
der erste Schwellenwert und der zweite Schwellenwert Werte sind, die auf der Grundlage mindestens eines von einer Nennrauschspannung, einer maximalen Eingangsspannung und einer momentanen maximalen Eingangsspannung einer vorbestimmten Schaltungseinheit (SP) eingestellt werden.

7. Elektronische Vorrichtung (1) nach Anspruch 6, wobei
das Eingangssignal und das Ausgangssignal Audiosignale sind, und
die vorbestimmte Schaltungseinheit (SP) ein Lautsprecher (SP) ist, in den das von dem Verstärker (40) ausgegebene Audiosignal eingegeben wird.

8. Elektronische Vorrichtung (1) nach Anspruch 7, weiter umfassend:
einen Speicher (32), der eine Vielzahl von Typen des ersten Musters und des zweiten Musters entsprechend den Vielzahl von Typen des Lautsprechers (SP) speichert, wobei
der mindestens eine Prozessor (30) konfiguriert ist zum:
Erhalten des ersten Musters und des zweiten Musters, die einem Typ des Lautsprechers (SP) entsprechen, der ein Ausgangsziel des Verstärkers (40) ist, aus der Vielzahl von Typen des ersten Musters und des zweiten Musters; und
Steuern des Verstärkers (40) in dem erhaltenen ersten Muster und zweiten Muster.

9. Elektronische Vorrichtung (1) nach einem der Ansprüche 1 bis 8, wobei
die elektronische Vorrichtung (1) ein elektronisches Musikinstrument mit einer Vielzahl von Tasten (60) ist.

10. Verfahren, das von mindestens einem Prozessor (30) durchgeführt wird, umfassend:
Erhalten eines Wertes (CCV), der einen Stromverbrauch in der einem Verstärker (40) zugeführten Leistung angibt, der so konfiguriert ist, dass er ein Eingangssignal verstärkt und ein Ausgangssignal ausgibt, das durch Formen des verstärkten Eingangssignals erhalten wird;
Steuern des Verstärkers (40) in einem ersten Muster, so dass ein Begrenzungswert für das Ausgangssignal abnimmt, wenn detektiert wird, dass der Wert größer als ein Referenzpotential ist und dass der Wert größer als ein erster Schwellenwert wird, der größer als ein zweiter Schwellenwert ist, ausgehend von einem Zustand, in dem er kleiner als der zweite Schwellenwert ist; und
Steuern des Verstärkers (40) in einem zweiten Muster, so dass der Begrenzungswert für das Ausgangssignal zunimmt, wenn detektiert wird, dass der Wert größer als das Referenzpotential ist und dass der Wert kleiner als der zweite Schwellenwert wird, ausgehend von einem Zustand, in dem er größer als der erste Schwellenwert ist.

11. Programm, das mindestens einen Prozessor (30) dazu veranlasst, den Prozess auszuführen, wobei der Prozess umfasst:
Erhalten eines Wertes (CCV), der einen Stromverbrauch in einem Verstärker (40) angibt, der so konfiguriert ist, dass er ein Eingangssignal verstärkt und ein Ausgangssignal ausgibt, das durch Formen des verstärkten Eingangssignals erhalten wird;
Steuern des Verstärkers (40) in einem ersten Muster, so dass ein Begrenzungswert für das Ausgangssignal abnimmt, wenn detektiert wird, dass der Wert größer als ein Referenzpotential ist und dass der Wert größer als ein erster Schwellenwert wird, der größer als ein zweiter Schwellenwert ist, ausgehend von einem Zustand, in dem er kleiner als der zweite Schwellenwert ist; und
Steuern des Verstärkers (40) in einem zweiten Muster, so dass der Begrenzungswert für das Ausgangssignal zunimmt, wenn detektiert wird, dass der Wert größer als das Referenzpotential ist und dass der Wert kleiner als der zweite Schwellenwert wird, ausgehend von einem Zustand, in dem er größer als der erste Schwellenwert ist.

## Revendications

1. Dispositif électronique (1) comprenant :
un amplificateur (40) configuré pour amplifier un signal d'entrée et émettre un signal de sortie obtenu par mise en forme du signal d'entrée amplifié ; et
au moins un processeur (30),
ledit au moins un processeur (30) étant configuré pour :
obtenir une valeur (CCV) indiquant une consommation de courant dans l'amplificateur (40) ;
commander l'amplificateur (40) selon un premier mode de manière qu'une valeur d'écrêtage du signal de sortie diminue, lorsqu'il détecte que la valeur est supérieure à un potentiel de référence et que la valeur devienne supérieure à un premier seuil supérieur à un second seuil à partir d'un état où elle est inférieure au second seuil ; et
commander l'amplificateur (40) selon un second mode de manière que la valeur d'écrêtage du signal de sortie augmente, lorsqu'il détecte que la valeur est supérieure au potentiel de référence et que la valeur devienne inférieure au second seuil à partir d'un état où elle est supérieure au premier seuil.

2. Dispositif électronique (1) selon la revendication 1, dans lequel ledit au moins un processeur (30) est configuré pour
établir le premier mode de manière qu'au moins un des signaux caractéristiques inclus dans le signal de sortie ne soit pas mis en forme par l'amplificateur (40).

3. Dispositif électronique (1) selon la revendication 1, dans lequel
le premier mode est un mode dans lequel la valeur d'écrêtage du signal de sortie diminue avec le temps, et
le second mode est un mode dans lequel la valeur d'écrêtage du signal de sortie augmente avec le temps.

4. Dispositif électronique (1) selon la revendication 1, dans lequel
l'amplificateur (40) comprend un circuit d'écrêtage (42) configuré pour écrêter le signal de sortie, et
ledit au moins un processeur (30) est configuré pour :
modifier une valeur d'écrêtage du circuit d'écrêtage (42) dans le premier mode de manière que la valeur d'écrêtage du signal de sortie diminue avec le temps, lorsque la valeur est supérieure au premier seuil ; et
modifier la valeur d'écrêtage dans le second mode de manière que la valeur d'écrêtage du signal de sortie augmente avec le temps, lorsque la valeur est inférieure au second seuil.

5. Dispositif électronique (1) selon la revendication 1, dans lequel
ledit au moins un processeur (30) est configuré pour :
obtenir, avec un circuit de maintien de crête (20) configuré pour détecter une valeur de crête d'une valeur mesurée par un amplificateur de détection de courant (10) installé sur un chemin d'alimentation électrique menant à l'amplificateur (40), la valeur indiquant l'énergie basée sur la valeur de crête détectée.

6. Dispositif électronique (1) selon la revendication 1, dans lequel
le premier seuil et le second seuil sont des valeurs fixées sur la base d'au moins l'une parmi une tension de bruit nominale, une tension d'entrée maximale, et une tension d'entrée maximale instantanée d'une unité de circuit (SP) préétablie.

7. Dispositif électronique (1) selon la revendication 6, dans lequel
le signal d'entrée et le signal de sortie sont des signaux audio, et
l'unité de circuit (SP) préétablie est un haut-parleur (SP) auquel est envoyé le signal audio émis par l'amplificateur (40).

8. Dispositif électronique (1) selon la revendication 7, comprenant en outre :
une mémoire (32) mémorisant une pluralité de types du premier mode et du second mode correspondant à la pluralité de types du haut-parleur (SP), dans lequel
ledit au moins un processeur (30) est configuré pour :
obtenir le premier mode et le second mode correspondant à un type du haut-parleur (SP) qui est une destination de sortie de l'amplificateur (40) parmi la pluralité de types du premier mode et du second mode ; et
commander l'amplificateur (40) dans le premier mode et le second mode obtenus.

9. Dispositif électronique (1) selon l'une quelconque des revendications 1 à 8, dans lequel
le dispositif électronique (1) est un instrument de musique électronique comportant une pluralité de touches (60).

10. Procédé exécuté par au moins un processeur (30), comprenant les étapes consistant à :
obtenir une valeur (CCV) indiquant une consommation de courant dans l'énergie fournie à un amplificateur (40) configuré pour amplifier un signal d'entrée et émettre un signal de sortie obtenu par mise en forme du signal d'entrée amplifié ;
commander l'amplificateur (40) selon un premier mode de manière qu'une valeur d'écrêtage du signal de sortie diminue, lorsqu'il détecte que la valeur est supérieure à un potentiel de référence et que la valeur devienne supérieure à un premier seuil supérieur à un second seuil à partir d'un état où elle est inférieure au second seuil ; et
commander l'amplificateur (40) selon un second mode de manière que la valeur d'écrêtage du signal de sortie augmente, lorsqu'il détecte que la valeur est supérieure au potentiel de référence et que la valeur devienne inférieure au second seuil à partir d'un état où elle est supérieure au premier seuil.

11. Programme destiné à amener au moins un processeur (30) à exécuter un processus, le processus comprenant :
obtenir une valeur (CCV) indiquant une consommation de courant dans un amplificateur (40) configuré pour amplifier un signal d'entrée et émettre un signal de sortie obtenu par mise en forme du signal d'entrée amplifié ;
commander l'amplificateur (40) selon un premier mode de manière qu'une valeur d'écrêtage du signal de sortie diminue, lorsqu'il détecte que la valeur est supérieure à un potentiel de référence et que la valeur devienne supérieure à un premier seuil supérieur à un second seuil à partir d'un état où elle est inférieure au second seuil ; et
commander l'amplificateur (40) selon un second mode de manière que la valeur d'écrêtage du signal de sortie augmente, lorsqu'il détecte que la valeur est supérieure au potentiel de référence et que la valeur devienne inférieure au second seuil à partir d'un état où elle est supérieure au premier seuil.
